# EUROPEAN PATENT SPECIFICATION

(11) **EP 3 507 645 B1**
(45) Date of publication and mention of the grant of the patent: **10.08.2022**
(21) Application number: 17845542.4
(22) Date of filing: 31.08.2017
(51) Int. Cl.: G02B 26/08, H02N 2/00

(54) **PIEZOELECTRIC ACTUATOR, DEFORMABLE MIRROR AND METHOD FOR MANUFACTURING DEFORMABLE MIRROR**
PIEZOELEKTRISCHER AKTUATOR, VERFORMBARER SPIEGEL UND VERFAHREN ZUR HERSTELLUNG EINES VERFORMBAREN SPIEGELS
ACTIONNEUR PIÉZOÉLECTRIQUE, MIROIR DÉFORMABLE ET PROCÉDÉ DE FABRICATION DE MIROIR DÉFORMABLE

(30) Priority: 31.08.2016 CN 201610797960
(43) Date of publication of application: 10.07.2019
(73) Proprietor: Beijing Supersonic Technology Co., Ltd., Beijing 100192 (CN)
(72) Inventor: LIU, Guoxi, Beijing 100192 (CN); WANG, Penghui, Beijing 100192 (CN); WANG, Zhipeng, Beijing 100192 (CN); SHI, Huaduo, Beijing 100192 (CN)
(74) Representative: Ponti & Partners, S.L.P
(86) International application number: PCT/CN2017/100094
(87) International publication number: WO 2018/041240

(56) References cited:
- WO-A1-2011/135943
- WO-A1-2013/100860
- CN-A- 106 199 949
- CN-U- 206 133 113
- JP-A- 2011 170 298
- JP-A- 2013 110 886
- US-A- 4 736 132
- US-A1- 2008 202 222
- US-A1- 2009 323 150

## Description

### Technical Field

The present invention relates to the technical field of piezoelectric actuation technology and deformable mirrors, and particularly to a piezoelectric actuator, a deformable mirror and a method for manufacturing the deformable mirror.

### Background Art

A deformable mirror is an ideal curved mirror surface formed by combining a plurality of small mirror units that can be controlled independently. Such deformable mirror is mainly used in an adaptive optical system, and by position operation on each independent small mirror units, the wavefront phase structure of the incident light wave can be changed, so as to achieve the objects of focusing, distortion correction of a high-order image, etc.

However, at present, there are many defects in the control over the small mirror units. The most common piezoelectric actuators at present are lead zirconate titanate (PZT) piezoelectric ceramic multilayered drivers that generate axial displacement and monomorph and bimorph drivers that generate transverse curved displacement. The defects are as follows: first, at present, most commercial PZT multilayered drivers and monomorph and bimorph drivers are single degree-of-freedom actuators, and are highly unsuitable for such deformable mirrors formed by combining small mirror units; and second, the combined use of the multilayered drivers and monomorph and bimorph drivers will result in excessively large external dimension, which also cannot be applied to such deformable mirrors formed by combining small mirrors. For example, WO2013100860A1 discloses a cost-effective single crystal multi-state actuator, US2008202222A1 discloses a multi-dimensional standing wave probe, and JP2011170298A discloses a method for manufacturing spatial light modulator, a spatial light modulator, an illumination light generating device, and an exposure device. Therefore, the piezoelectric actuators having a small volume and high degree of freedom are needed to solve the problems.

### Disclosure of the Invention

In order to solve at least one of the problems in the prior art, the present invention as defined in claim 1 is proposed.

Preferably, the end-face-edges of the first piezoelectric single crystal and the second piezoelectric single crystal which are connected with the level connector are parallel to each other, and the end-face-edges of the third piezoelectric single crystal and the fourth piezoelectric single crystal which are connected with the level connector are parallel to each other.

Preferably, connection positions where the first piezoelectric single crystal and the second piezoelectric single crystal are connected with the level connector, and connection positions where the third piezoelectric single crystal and the fourth piezoelectric single crystal are connected with the level connector have projections on either of the first surface and the second surface of the level connector, with the projections orthogonal to each other.

Preferably, the first surface of the level connector is provided with two parallel strip-shaped recesses, the second surface of the level connector is provided with two parallel strip-shaped recesses; the end of the first piezoelectric single crystal which is connected with the level connector, the end of the second piezoelectric single crystal which is connected with the level connector, the end of the third piezoelectric single crystal which is connected with the level connector and the end of the fourth piezoelectric single crystal which is connected with the level connector are fixed in different strip-shaped recesses, and the strip-shaped recesses on the first surface are orthogonal to the strip-shaped recesses on the second surface.

Preferably, the single crystal component of each of the first piezoelectric single crystal, the second piezoelectric single crystal, the third piezoelectric single crystal and the fourth piezoelectric single crystal comprises at least one of lead zinc niobate-lead titanate, lead magnesium niobate-lead titanate, lead indium niobate-lead magnesium niobate-lead titanate, and lead magnesium niobate-lead zirconate titanate.

Preferably, the first piezoelectric single crystal, the second piezoelectric single crystal, the third piezoelectric single crystal and the fourth piezoelectric single crystal are all in a transverse operating mode, preferably d₃₁ or d₃₂ mode.

A deformable mirror comprises a plurality of mirror bodies and a plurality of piezoelectric actuators, wherein all the mirror bodies are located on a same side of the level connector, and the mirror bodies are each bonded at the ends of the first piezoelectric single crystal and the second piezoelectric single crystal of one piezoelectric actuator, which are not connected with the level connector; or the mirror bodies are each bonded at the ends of the third piezoelectric single crystal and the fourth piezoelectric single crystal of one piezoelectric actuator, which are not connected with the level connector.

Preferably, the first piezoelectric single crystal, the second piezoelectric single crystal, the third piezoelectric single crystal and the fourth piezoelectric single crystal are made of solid solution single crystals, comprising at least one selected from the group consisting of the following components: lead zinc niobate-lead titanate (Pb(Zn_{1/3}Nb_{2/3})O₃-PbTiO₃), lead magnesium niobate-lead titanate (Pb(Mg_{1/3}Nb_{2/3})O₃-PbTiO₃), lead magnesium niobate-lead zirconate titanate (Pb(Mg_{1/3}Nb_{2/3})O₃-PbZrO₃-PbTiO₃), lead indium niobate-lead magnesium niobate-lead titanate (Pb(In_{1/2}Nb_{1/2})O₃-Pb(Mg_{1/3}Nb_{2/3})O₃-PbTiO₃), and derivative components of them.

Preferably, the first piezoelectric single crystal, the second piezoelectric single crystal, the third piezoelectric single crystal and the fourth piezoelectric single crystal are all in a rectangular plate-like structure made of [011]-crystal orientation polarized, d₃₂ or d₃₁-mode single crystals.

Preferably, the level connector is in a rectangular plate-like structure.

Preferably, the first piezoelectric single crystal, the second piezoelectric single crystal, the third piezoelectric single crystal and the fourth piezoelectric single crystal each has their length direction parallel with the axial direction of the piezoelectric actuator and a width direction parallel with a length direction of the level connector, and a width direction parallel with a length direction of the level connector.

Preferably, the first connection surface is provided thereon with two parallel recesses, the second connection surface is provided thereon with two parallel recesses, and the recesses on the first connection surface are perpendicular to the recesses on the second connection surface; and
the first piezoelectric single crystal and the second piezoelectric single crystal are bonded in the recesses on the first connection surface, and the third piezoelectric single crystal and the fourth piezoelectric single crystal are bonded in the recesses on the second connection surface.

Preferably, the base comprises an upper surface parallel with the first connection surface, and the upper surface is provided thereon with recesses that are arranged in parallel and spaced apart;
the first piezoelectric single crystal and the second piezoelectric single crystal are connected with two recesses on the upper surface of the base, respectively;
the pedestal comprises a lower surface parallel with the second connection surface, and the lower surface is provided thereon with recesses that are arranged in parallel and spaced apart; and
the third piezoelectric single crystal and the fourth piezoelectric single crystal are connected with two recesses on the lower surface of the pedestal, respectively.

Preferably, the first piezoelectric single crystal, the second piezoelectric single crystal, the third piezoelectric single crystal and the fourth piezoelectric single crystal may be of same size or may be not of same size.

Preferably, the first direction is perpendicular to the second direction.

Preferably, the first piezoelectric single crystal, the second piezoelectric single crystal, the third piezoelectric single crystal and the fourth piezoelectric single crystal are all in a strip-like structure.

A deformable mirror comprises a plurality of piezoelectric actuators that are arranged in a matrix.

A method for manufacturing the deformable mirror comprises the steps of:
a. mounting bases of a plurality of piezoelectric actuators on a rigid base and arranging the plurality of piezoelectric actuators in a matrix; and
b. performing flat-lapping and mirror-polishing on upper surfaces of the pedestals of the plurality of piezoelectric actuators.

Preferably, after polishing of the upper surface of the pedestal, the upper surface of the pedestal is further covered with a coating having high reflectivity.

A method for manufacturing the deformable mirror comprises the steps of:
a. mounting bases of a plurality of piezoelectric actuators on a rigid base and arranging the plurality of piezoelectric actuators in a matrix;
b. performing flat-lapping on the upper surfaces of the pedestals of the plurality of piezoelectric actuators; and
c. bonding a small mirror body onto the upper surface of the pedestal of each of the plurality of piezoelectric actuators.

### Brief Description of Drawings

In order to more clearly illustrate the technical solutions of the embodiments of the present invention, brief description is made below on the drawings required to be used in the embodiments. It should be understood that the following drawings only illustrate some of the embodiments of the present invention and shall not be regarded as limiting the scope, and for a person of ordinary skills in the art, other related drawings may be obtained from these drawings without using inventive efforts.
FIG. 1 is a schematic structural diagram of a piezoelectric actuator in an unactuated state according to a preferred embodiment of the present invention;
FIG. 2 is a schematic structural diagram of the piezoelectric actuator in an actuated state according to a preferred embodiment of the present invention;
FIG. 3 is a field-induced strain graph of a [011]-crystal orientation polarized PZN-5.5%PT d₃₂ transverse-mode single crystal bar according to a preferred embodiment of the present invention;
FIG. 4 is a schematic structural diagram of a piezoelectric actuator without a base and a pedestal according to a preferred embodiment of the present invention;
FIG. 5 is a schematic structural diagram of a deformable mirror in an unactuated state according to a preferred embodiment of the present invention; and
FIG. 6 is a schematic structural diagram of the deformable mirror in an actuated state according to a preferred embodiment of the present invention.

### Detailed Description of Embodiments

In order to make the objects, technical solutions and advantages of the embodiments of the present invention clearer, the technical solutions of the embodiments of the present invention will be described below clearly and completely with reference to the drawings of the embodiments of the present invention. Apparently, the embodiments described are some of the embodiments of the present invention, rather than all of the embodiments. The components of the embodiments of the present invention described and illustrated in the drawings herein can generally be arranged and designed in a variety of different configurations.

Thus, the following detailed description of the embodiments of the present invention provided in the drawings is not intended to limit the scope of the claimed invention, but is merely representative of the selected embodiments of the present invention.

It should be noted that similar reference signs and letters denote similar items in the drawings, and therefore, once a certain item is defined in one figure, it does not need to be further defined and explained in the subsequent figures.

In the description of the present invention, it should be noted that the orientation or position relations indicated by the terms "upper", "lower", "internal", "external", etc. are the orientation or position relations illustrated in the drawings, the orientation or position relations conventionally arranged in the use of the product of the present invention, or the orientation or position relations conventionally understood by a person skilled in the art, which merely serve to facilitate describing the present invention and simplifying the description, rather than indicating or implying that the device or element referred to must have a particular orientation, be constructed and operated in a particular orientation, and therefore cannot be construed as a limit to the present invention.

In addition, the terms "first", "second", "third", etc. are only used for differentiated description, but cannot be construed as an indication or suggestion of importance in relativity.

In the description of the present invention, it should further be noted that, unless otherwise explicitly specified and limited, the terms "arrange", "mount" and "connect" shall be understood in broad sense, for example, "connect" may refer to fixed connection, detachable connection or integral connection; may refer to mechanical connection or electrical connection; and may also refer to direct connection, indirect connection by means of an intermediate medium, or communication between two elements. A person of ordinary skills in the art can understand the specific meaning of the terms in the present invention according to specific situations.

### First Embodiment:

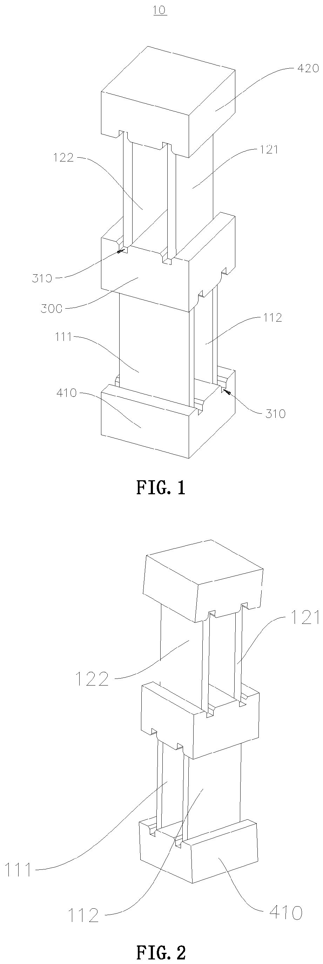

Referring to FIG. 1, the present embodiment provides a piezoelectric actuator 10 comprising a level connector 300, a first piezoelectric single crystal 111, a second piezoelectric single crystal 112, a third piezoelectric single crystal 121, a fourth piezoelectric single crystal 122, a base 410 and a pedestal 420.

The level connector 300 is used for mounting the first piezoelectric single crystal 111, the second piezoelectric single crystal 112, the third piezoelectric single crystal 121 and the fourth piezoelectric single crystal 122, and can transfer an adjusted angle.

Preferably, the shape of the main body of the level connector 300 includes, but is not limited to, a rectangular or square structure, and in addition, other irregular shapes such as a circle and an ellipse are also suitable. The level connector 300 has two parallel surfaces, i.e., a first surface and a second surface, opposite to each other. On the level connector 300, a recess 310 structure can be provided, with two recesses on the first surface and two recesses on the second surface. The recesses 310 are used to enhance the stability of the connection between the level connector 300 and the first piezoelectric single crystal 111, the second piezoelectric single crystal 112, the third piezoelectric single crystal 121 and the fourth piezoelectric single crystal 122 (four piezoelectric single crystals are respectively embedded into different recesses 310 and are fixedly connected thereto). The recesses 310 may be in a strip-shaped recess 310 structure, but is not limited thereto. The arrangement manner of the recesses 310 (the connection positions of the piezoelectric single crystals with the level connector 300) may be, but is not limited to, that two recesses 310 are arranged in parallel on the same surface, and the recess 310 structures on the first surface are arranged orthogonal (perpendicular) to the recess 310 structures on the second surface.

The first piezoelectric single crystal 111, the second piezoelectric single crystal 112, the third piezoelectric single crystal 121 and the fourth piezoelectric single crystal 122 are used for receiving voltage excitation to deform (mainly change the length) so as to drive the devices or components connected to the ends of them.

The first piezoelectric single crystal 111 and the second piezoelectric single crystal 112 are mounted on the first surface of the level connector 300 and are mounted at different positions; and the third piezoelectric single crystal 121 and the fourth piezoelectric single crystal 122 are mounted on the second surface of the level connector 300 and are mounted at different positions, thereby forming a two-layered structure. Among the connection positions between the first to fourth piezoelectric single crystals 111, 112, 121 and 122 and the level connector 300, the projections of the connection positions on the first surface or the second surface of the level connector 300 do not overlap each other. When the first piezoelectric single crystal 111, the second piezoelectric single crystal 112, the third piezoelectric single crystal 121, and the fourth piezoelectric single crystal 122 are all of a rectangular shape (not limited thereto), it can be understood that they are distributed to intersect one another, for example, orthogonal and oblique crossing etc. The connection manner may be bonding, soldering, welding, etc., which is not limited.

Preferably, when the piezoelectric single crystals are all of a rectangular shape (i.e., single crystal bars), the four piezoelectric single crystals may have the same size, that is, each layer is composed of two single crystal bars. When the two single crystals of each layer are excited by the same voltage, the front end surfaces thereof will make displacement in an axial direction (the axial direction is equivalent to the direction perpendicular to the surface of the connecting layer 300), but when they are excited by different voltages, the front end surfaces of the two single crystals on each side can make axial and tilted displacement (driving surface: a driving surface is formed by one end of the third piezoelectric single crystal 121 and one end of the fourth piezoelectric single crystal 122 which are not connected with the level connector 300, with the driving surface capable of being driven by the third piezoelectric single crystal 121 and the fourth piezoelectric single crystal 122 to tilt in a second direction, the first direction and the second direction are different directions; and in this case, the first piezoelectric single crystal 111 and the second piezoelectric single crystal 112 drive the level connector 300). One group of single crystals (the third and fourth piezoelectric single crystals) are stacked on the other group of single crystals (the first and second piezoelectric single crystals), and the tilted rotation axes of the two groups of single crystals are in an orthogonal arrangement, so that the three-degree-of-freedom driving effect can be obtained.

Referring to FIG. 2, this figure shows the post-actuated state of the piezoelectric actuator 10. It can be seen that after the first piezoelectric single crystal 111, the second piezoelectric single crystal 112, the third piezoelectric single crystal 121 and the fourth piezoelectric single crystal 122 are excited at different voltages to undergo strains, the first piezoelectric single crystal 111 is longer than the second piezoelectric single crystal 112, and the third piezoelectric single crystal 121 is longer than the fourth piezoelectric single crystal 122, so that the driving surfaces are finally tilted, achieving the object of driving.

Preferably, the first piezoelectric single crystal 111, the second piezoelectric single crystal 112, the third piezoelectric single crystal 121 and the fourth piezoelectric single crystal 122 may be, but are not limited to, [011]-crystal orientation polarized lead-based ferroelectric relaxor single crystal, and the components thereof may be, but are not limited to, lead zinc niobate-lead titanate (PZN-PT), lead magnesium niobate-lead titanate (PMN-PT), lead indium niobate-lead magnesium niobate-lead titanate (PIN-PMN-PT), lead magnesium niobate-lead zirconate titanate (PMN-PZT), and derivative components thereof. Such crystal orientation polarized lead-based ferroelectric relaxor single crystal has higher transverse piezoelectric coefficients d₃₁ and d₃₂ than the piezoelectric ceramic. For example, the d₃₂ and d₃₁ values of the PZN-PT single crystal are -(3200-4000) pC/N and 1100 pC/N, respectively. This type of piezoelectric material is particularly suitable for the manufacture of drivers with high axial strain.

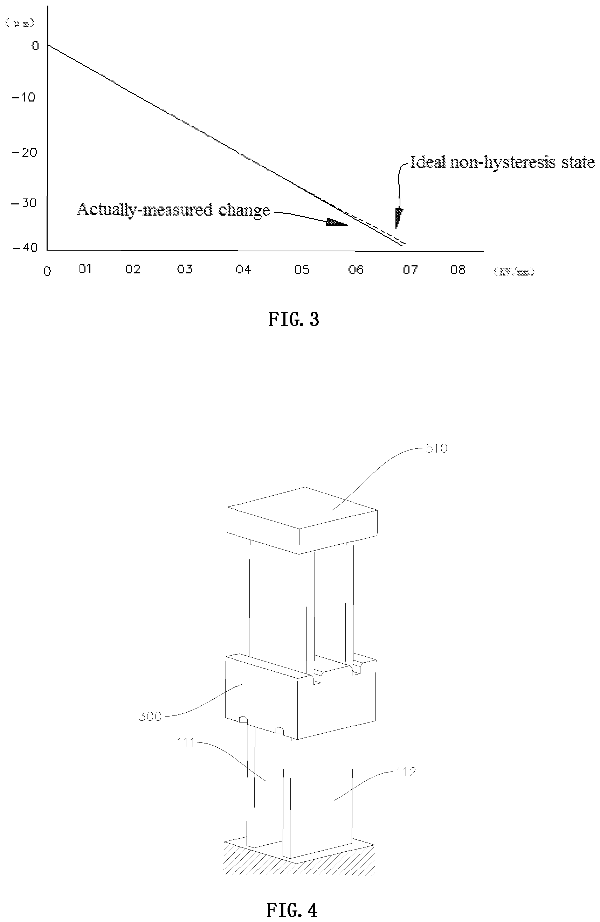

When the excitation field intensity is lower than the intensity of the phase transformation electric field and the operation frequency is relatively low, the transverse-mode bar of the [011]-crystal orientation polarized lead-based relaxor single crystal exhibits an extremely low strain hysteresis. Preferably, the transverse mode that can be used by the first piezoelectric single crystal 111, the second piezoelectric single crystal 112, the third piezoelectric single crystal 121 and the fourth piezoelectric single crystal 122 in the present invention is [011]-crystal orientation polarized, [100]-direction driven d₃₂ mode. For example, such type of bars made of PZN-5.5%PT single crystals have a high transverse piezoelectric coefficient (d₃₂ ≈ -2200-2500 pC/N), high phase transformation electric field and [100]-direction high phase transformation stress intensity (the phase transformation electric field E_{RO} is 0.8 kV/mm and the phase transformation stress intensity σ_{RO} is 12 MPa). As shown in FIG. 3, the field-induced strain curve of the [011]-crystal orientation polarized PZN-5.5%PT d₃₂ transverse-mode single crystal bar is shown, in which the horizontal axis represents the electric field intensity, and the longitudinal axis represents the strain. As can be seen from the figure, this type of single crystals exhibit a large strain and no obvious strain hysteresis (wherein the dashed line indicates the ideal non-hysteresis state, the solid line indicates the actually-measured change, of which the minor differences can be ignored and which are very close to the ideal state). Such type of single crystals with a large strain and no obvious strain hysteresis can be used as a preferred material for manufacturing a driving device for small mirrors of the deformable mirror 20.

The base 410 and the pedestal 420 are used for fixing or mounting other devices, such as small mirrors.

The base 410 is provided at the ends of the first piezoelectric single crystal 111 and the second piezoelectric single crystal 112 away from the level connector 300. The pedestal 420 is provided at the ends of the third piezoelectric single crystal 121 and the fourth piezoelectric single crystal 122 away from the level connector 300. For example, the base 410 may be configured as a fixed base, and the pedestal 420 may be configured as a bearing platform for mounting the driven devices. It should be noted that if there are no pedestal and base, it is feasible to directly fix the end surfaces of the piezoelectric single crystals at one side onto other planes or devices, and directly fixedly connect the end surfaces of the piezoelectric single crystals at the other side onto the driven objects or devices, as shown in FIG. 4. Recesses 310 may also be provided at the positions, where the pedestal and base are connected with the first piezoelectric single crystal 111, the second piezoelectric single crystal 112, the third piezoelectric single crystal 121 and the fourth piezoelectric single crystal 122, for connection.

In the piezoelectric actuator 10 provided in the present invention, the first surface of the level connector 300 is provided with the first piezoelectric single crystal 111 and the second piezoelectric single crystal 112, the second surface of the level connector 300 is provided with the third piezoelectric single crystal 121 and the fourth piezoelectric single crystal 122, the first surface and the second surface are the two opposite side surfaces of the level connector 300, the first piezoelectric single crystal 111, the second piezoelectric single crystal 112, the third piezoelectric single crystal 121 and the fourth piezoelectric single crystal 122 are connected at different positions of the level connector 300, and the projections of the connection positions on the first surface or the second surface of the level connector 300 do not overlap each other. That is, the first piezoelectric single crystal 111 and the second piezoelectric single crystal 112 are in a direction, and the third piezoelectric single crystal 121 and the fourth piezoelectric single crystal 122 are in another direction. In this way, by applying a voltage to the first piezoelectric single crystal 111 and the second piezoelectric single crystal 112, the first piezoelectric single crystal 111 and the second piezoelectric single crystal 112 deform (extend or shorten), so as to adjust the tilt angle or the lifting height of the level connector 300 in one direction; and by applying a voltage to the third piezoelectric single crystal 121 and the fourth piezoelectric single crystal 122, the third piezoelectric single crystal 121 and the fourth piezoelectric single crystal 122 deform, so as to adjust the tilt angle or the lifting height of the end surfaces thereof in another direction. The two adjusted angles are transferred through the level connector 300 to the ends (the driving surface formed by the third piezoelectric single crystal 121 and the fourth piezoelectric single crystal 122) of the piezoelectric single crystals on the same side of the level connector 300, thereby achieving the adjustment of the angles in the two directions. Moreover, the adjustment of the axial length can be achieved by the length variations of the piezoelectric single crystals in the axial direction, that is, three-degree-of-freedom control over the piezoelectric actuator 10 is achieved.

### Second Embodiment

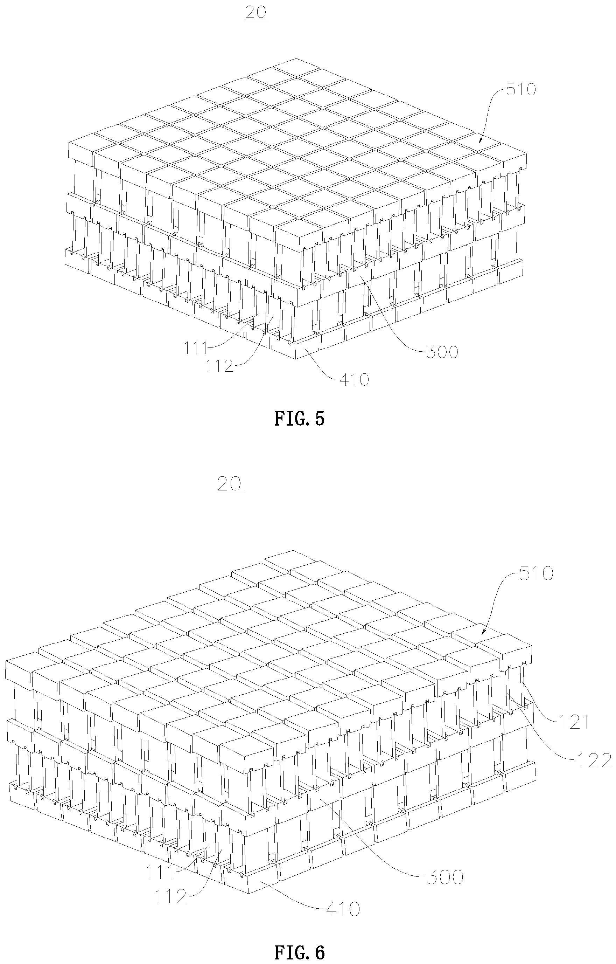

Referring to FIG. 5, the present embodiment provides a deformable mirror 20 using the piezoelectric actuator 10 of the first embodiment. FIG. 5 and FIG. 6 are schematic structural diagrams of the 9×9 deformable mirror 20 using the piezoelectric actuator 10 of the first embodiment in different states.

Preferably, the deformable mirror 20 comprises a plurality of mirror bodies 510 and a plurality of piezoelectric actuators 10, the mirror bodies 510 each are located at the same side of the level connector 300, and the mirror bodies 510 each are arranged at the end surfaces of the ends of the first piezoelectric single crystal 111 and the second piezoelectric single crystal 112 of one piezoelectric actuator 10, which are not connected with the level connector 300; or the mirror bodies 510 each are arranged at the end surfaces of the ends of the third piezoelectric single crystal 121 and of the fourth piezoelectric single crystal 122 of one piezoelectric actuator 10, which are not connected with the level connector 300.

Preferably, the individual mirror bodies 510 respectively may be mounted on the bases 410 or the pedestals 420 of the plurality of piezoelectric actuators 10, and may also be directly connected to the end surfaces of the first piezoelectric single crystal 111 and the second piezoelectric single crystal 112 away from the level connector 300, or directly connected to the end surfaces of the third piezoelectric single crystal 121 and the fourth piezoelectric single crystal 122 away from the level connector 300. The unconnected end surfaces may be provided with a base or a pedestal as a fixed layer or directly fixed to other devices. Each piezoelectric actuator 10 can independently control one mirror body 510. Each mirror body 510 is one of the small mirrors constituting a complete deformable mirror 20.

Referring to FIG. 6, this figure is a schematic diagram of the deformable mirror 20 that has been driven by the piezoelectric actuator 10. It can be seen that after the first piezoelectric single crystal 111, the second piezoelectric single crystal 112, the third piezoelectric single crystal 121 and the fourth piezoelectric single crystal 122 are excited by different voltages respectively to undergo strains, the first piezoelectric single crystal 111 is longer than the second piezoelectric single crystal 112, and the third piezoelectric single crystal 121 is longer than the fourth piezoelectric single crystal 122, so that the entire surface of the deformable mirror 20 is finally tilted. Of course, in practical applications, each piezoelectric actuator 10 is separately controlled, and therefore each of the driven mirror bodies 510 may undergo a different variation.

For the deformable mirror 20 having a certain size, the more small mirror units it has, the stronger the optical adaptability thereof is. The number of piezoelectric small mirrors in the deformable mirror 20 is generally several tens or even hundreds, and these small mirrors need to be separately controlled, thus, strain hysteresis will significantly increase the difficulty in the control. The use of such piezoelectric actuator 10 will provide the advantages such as high response speed, small strain hysteresis and high displacement and improved resolution, which greatly reduces the axial and tilted displacement deviations of the piezoelectric actuator, and also reduces the difficulty in controlling the piezoelectric actuator in the deformable mirror 20.

For example, if the above-mentioned small mirrors are driven by four PZN-5.5%PT d₃₂ single crystal bars having a size of 7mm (L)×4mm (W)×0.5mm (T), under the excitation of a 400V unidirectional voltage, the maximum values of the total axial displacement and full tilt angle width are 15 µm and 0.3 degree, respectively.

For the deformable mirror 20 using the piezoelectric actuator 10 of the first embodiment provided in the present embodiment, by mounting each of the small mirror units on the deformable mirror 20 at the ends of the first piezoelectric single crystal 111 and the second piezoelectric single crystal 112 of one piezoelectric actuator 10 away from the level connector 300, or at the ends of the third piezoelectric single crystal 121 and the fourth piezoelectric single crystal 122 of one piezoelectric actuator 10 away from the level connector 300, the deformable mirror 20 fixes the ends of the piezoelectric single crystals which are connected with the small mirror units. By means of the three-degree-of-freedom adjustment of the piezoelectric actuator 10, it is possible to separately control each of the small mirrors in three directions, and by means of control over each small mirrors, the control with higher accuracy over the large curved mirror surface of the entire deformable mirror 20 can be achieved, which reduces the control difficulty and control hysteresis, and increases the control flexibility.

In view of the above, the piezoelectric actuator 10 and the deformable mirror 20 provided in the present invention use the first piezoelectric single crystal 111, the second piezoelectric single crystal 112, the third piezoelectric single crystal 121 and the fourth piezoelectric single crystal 122 to form two groups of two-layered structures; and the rotation axes of the driving surfaces of each group of piezoelectric single crystals intersect so as to achieve, after the excitation by a voltage, the driving effect of driving the ends of one group of piezoelectric single crystals away from the level connector 300 (tilted displacement and axial displacement in two directions) to obtain three degrees of freedom, thereby driving the mirror bodies 510 of the deformable mirror 20 to achieve multi-degree-of-freedom driving effect.

### Third Embodiment

As shown in FIG. 1, the present embodiment provides a piezoelectric actuator for the use in a deformable mirror, mainly comprising a level connector 300, a first piezoelectric single crystal 111, a second piezoelectric single crystal 112, a third piezoelectric single crystal 121, a fourth piezoelectric single crystal 122, a base 410 and a pedestal 420, wherein the first piezoelectric single crystal 111 and the second piezoelectric single crystal 112 are provided opposite to each other and spaced apart, and have one ends connected with the level connector and the other ends connected with the base; and the third piezoelectric single crystal 121 and the fourth piezoelectric single crystal 122 are provided opposite to each other and spaced apart, and have one ends connected with the level connector and the other ends connected with the pedestal 420.

As shown in FIG. 1 and FIG. 2, the level connector 300 comprises a first connection surface and a second connection surface opposite to each other, one end of the first piezoelectric single crystal 111 and one end of the second piezoelectric single crystal 112 are connected with the first connection surface respectively, the first piezoelectric single crystal 111 and the second piezoelectric single crystal 112 are arranged in parallel and spaced apart, and the arranging direction of the first piezoelectric single crystal and the second piezoelectric single crystal on the first connection surface is defined as a first direction. The free ends of the first piezoelectric single crystal 111 and the second piezoelectric single crystal 112 are provided with a base 410.

Similarly, one end of the third piezoelectric single crystal 121 and one end of the fourth piezoelectric single crystal 122 are connected with the second connection surface respectively, the third piezoelectric single crystal 121 and the fourth piezoelectric single crystal 122 are provided in parallel and spaced apart, and the arranging direction of the third piezoelectric single crystal and the fourth piezoelectric single crystal on the second connection surface is defined as a second direction which is at an angle to the first direction. The free ends of the third piezoelectric single crystal 121 and the fourth piezoelectric single crystal 122 are provided with a pedestal.

Further, the first piezoelectric single crystal, the second piezoelectric single crystal, the third piezoelectric single crystal and the fourth piezoelectric single crystal are all in a rectangular plate-like structure with the same size.

Of course, in other embodiments, it can also be the case that the first piezoelectric single crystal 111 and the second piezoelectric single crystal 112 are in a rectangular plate-like structure with the same size, and the third piezoelectric single crystal 121 and the fourth piezoelectric single crystal 122 are in a rectangular plate-like structure with the same size; and the two sizes may be different. Alternatively, the first piezoelectric single crystal and the second piezoelectric single crystal may be different in size, and the third piezoelectric single crystal and the fourth piezoelectric single crystal may also be different in size.

Alternatively, the four piezoelectric single crystals are not necessarily in a rectangular plate shape, instead, they may have other suitable shapes, for example, a strip shape.

Further, the level connector 300 is of a plate-like or a block-like structure, with two parallel recesses on the first connection surface and also parallel recesses on the second connection surface, and the recesses on the first connection surface and the recesses on the second connection surface are perpendicular to each other. One end of the first piezoelectric single crystal 111 and one end of the second piezoelectric single crystal 112 are bonded in the two recesses on the first connection surface respectively, and the other end of is bonded in the other recess in the first connection surface. The third piezoelectric single crystal 121 and the fourth piezoelectric single crystal 122 are respectively bonded in the two recesses on the second connection surface respectively.

The free ends of the first piezoelectric single crystal 111 and the second piezoelectric single crystal 112 are provided with a base 410 having an upper surface parallel to the first surface of the level connector 300, and the upper surface is provided thereon with two parallel recesses; and the free ends of the first piezoelectric single crystal 111 and the second piezoelectric single crystal 112 are respectively bonded in the two recesses of the base 410.

The free ends of the third piezoelectric single crystal 121 and the fourth piezoelectric single crystal 122 are provided with a pedestal 420. The pedestal 420 has a lower surface parallel to the second surface of the level connector 300, with the lower surface provided thereon with two parallel recesses; and the free ends of the third piezoelectric single crystal 121 and the fourth piezoelectric single crystal 122 are respectively bonded in the two recesses of the pedestal 420.

Of course, in other embodiments, the first piezoelectric single crystal 111, the second piezoelectric single crystal 112, the third piezoelectric single crystal 121 and the fourth piezoelectric single crystal 122 can be connected with the level connector 300, the base 410 and the pedestal 420 in other manners, e.g., bonding. In addition, it is merely a preferred embodiment that the recesses on the first connection surface are perpendicular to the recesses on the second connection surface, and in other embodiments, they may be arranged to form other angles.

The first piezoelectric single crystal 111, the second piezoelectric single crystal 112, the third piezoelectric single crystal 121 and the fourth piezoelectric single crystal 122 use piezoelectric active materials, and when an electric field or a voltage is applied by means of an external wire, these single crystals can extend or be contracted, and the electrode surfaces of these single crystals are on the two largest surfaces. For simplification, the connection wires are not shown in the figure.

Further, the first piezoelectric single crystal 111, the second piezoelectric single crystal 112, the third piezoelectric single crystal 121 and the fourth piezoelectric single crystal 122 are made of high piezoelectric relaxor solid solution single crystals, comprising at least one selected from the group consisting of the following components: lead zinc niobate-lead titanate (Pb(Zn_{1/3}Nb_{2/3})O₃-PbTiO₃), lead magnesium niobate-lead titanate (Pb(Mg_{1/3}Nb_{2/3})O₃-PbTiO₃), lead magnesium niobate-lead zirconate titanate (Pb(Mg_{1/3}Nb_{2/3})O₃-PbZrO₃-PbTiO₃), lead indium niobate-lead magnesium niobate-lead titanate (Pb(In_{1/2}Nb_{1/2})O₃-Pb(Mg_{1/3}Nb_{2/3})O₃-PbTiO₃), and derivative components of them. That is, the first piezoelectric single crystal 111, the second piezoelectric single crystal 112, the third piezoelectric single crystal 121 and the fourth piezoelectric single crystal 122 each comprise one or more of the components above.

Under the effects of a low frequency and relatively small external electric field (with intensity lower than that of the phase transformation electric field of single crystal), the [011]-crystal orientation polarized transverse-mode lead-based relaxor piezoelectric single crystal exhibits an extremely low strain hysteresis. Further, the first piezoelectric single crystal 111, the second piezoelectric single crystal 112, the third piezoelectric single crystal 121 and the fourth piezoelectric single crystal 122 in the present invention are made of [01 1]-crystal orientation polarized d₃₂-mode ([100] crystal orientation is used as the actuating direction) single crystals. For example, the [011]-crystal orientation polarized PZN-5.5%PT single crystal not only has a very high transverse piezoelectric coefficient d₃₂ ≈ -2400 pC/N, but also has a relatively high phase transformation electric field and axial phase transformation stress, which are 0.8 kV/mm and 10 MPa respectively.

FIG. 3 is an electric field-induced strain curve of the quasi-static [011]-crystal orientation polarized d₃₂-mode PZN-5.5%PT crystal, in which the abscissa indicates the external electric field intensity (kV/mm), and the ordinate indicates the induced strain. The figure shows that the single crystal has good axial strain linearity and extremely low strain hysteresis.

In other embodiments, the first piezoelectric single crystal 111, the second piezoelectric single crystal 112, the third piezoelectric single crystal 121 and the fourth piezoelectric single crystal 122 can use the [011]-crystal orientation polarized d₃₁ mode.

The working principle of the piezoelectric actuator provided in the present embodiment is as follows:
After the pedestal 420 is fixed, same voltage is applied to the four piezoelectric single crystals, and the four piezoelectric single crystals have the same extending or contracting amount, thereby causing the base 410 to move in a direction perpendicular to the pedestal 420, i.e., causing axial displacement.

When different voltages are applied to the third piezoelectric single crystal 121 and the fourth piezoelectric single crystal 122, the deformation amounts of them are different, or both the deformation amounts thereof and the deformation directions thereof are different, so that the pedestal 420 is tilted, that is, experiences turnover at a certain angle, and the rotation axis thereof is parallel with the recesses on the second connection surface; and when different voltages are applied to the first piezoelectric single crystal 111 and the second piezoelectric single crystal 112, the deformation amounts thereof are different, or both the deformation amounts thereof and the deformation directions thereof are different, so that the level connector 300 is tilted, the level connector 300 drives, through the third piezoelectric single crystal 121 and the fourth piezoelectric single crystal 122, the pedestal 420 to tilt and experience turnover at a certain angle, and the rotation axis thereof is parallel with the recesses on the first connection surface. Since there is an angle between the recesses on the first connection surface and the recesses on the second connection surface, in the two cases, there is also a certain angle between the rotation axes, and in the present embodiment, the angle is 90°, therefore two rotational degrees of freedom are produced, plus the free ends making axial displacement, there are three degrees of freedom in total.

In addition, since the first piezoelectric single crystal 111, the second piezoelectric single crystal 112, the third piezoelectric single crystal 121 and the fourth piezoelectric single crystal 122 are all made of [011]-crystal orientation polarized lead-based relaxor single crystals with ultra-high piezoelectric performance, the hysteresis effect is so small that it can be ignored.

It should be noted that "parallel" or "perpendicular" mentioned in the present invention does not mean "absolutely parallel" or "absolutely perpendicular", rather, there may be a certain deviation; in addition, the lower surface and the upper surface are both mentioned with reference to the drawings, and when the direction in the drawings is changed, the positions of the lower surface and the upper surface will be changed accordingly.

### Fourth Embodiment:

The present embodiment provides a deformable mirror using a plurality of piezoelectric actuators provided in the third embodiment, the plurality of piezoelectric actuators are arranged in a matrix and the bases are fixed on a rigid base. The upper surface of the pedestal is subjected to mirror-polishing and is covered with a coating having high reflectivity, which is specifically a metal coating. The present embodiment uses 81 piezoelectric actuators in a 9×9 arrangement.

### Fifth Embodiment:

The present embodiment provides a method for manufacturing the deformable mirror, comprising the steps of:
a. mirror-polishing the upper surface of the pedestal of each of the piezoelectric actuators in the third embodiment; and
b. mounting the bases of the piezoelectric actuators on a rigid base and arranging the plurality of piezoelectric actuators in a matrix. The bases can be connected with the rigid base by welding, bonding, clamping, bolting or the like.

Further, after mirror-polishing is performed, the upper surface of the pedestal is covered with a coating having high reflectivity.

### Sixth Embodiment

The present embodiment provides a method for manufacturing the deformable mirror, comprising the steps of:
a. mounting the bases of the piezoelectric actuators on a rigid base and arranging the plurality of piezoelectric actuators in a matrix. The bases can be connected with the rigid base by welding, bonding, clamping, soldering, bolting or the like; and
b. performing flat-lapping of the upper surfaces of the pedestals of the plurality of piezoelectric actuators; and
c. bonding a small mirror body onto the upper surface of the pedestal of each of the plurality of piezoelectric actuators.

The above are only preferred embodiments of the present invention, which are not used to limit the present invention. For a person skilled in the art, the present invention may have various modifications and variations.

### Industrial Applicability

According to the piezoelectric actuator provided in the present invention, a first surface of a level connector is provided with a first piezoelectric single crystal and a second piezoelectric single crystal, a second surface of the level connector is provided with a third piezoelectric single crystal and a fourth piezoelectric single crystal, the first surface and the second surface are two opposite side surfaces of the level connector, the first piezoelectric single crystal, the second piezoelectric single crystal, the third piezoelectric single crystal and the fourth piezoelectric single crystal are connected at different positions of the level connector, and the projections of the connection positions on the first surface or the second surface of the level connector do not overlap each other. That is, the first piezoelectric single crystal and the second piezoelectric single crystal are in one direction, and the third piezoelectric single crystal and the fourth piezoelectric single crystal are in another direction. In this way, by applying a voltage to the first piezoelectric single crystal and the second piezoelectric single crystal, the first piezoelectric single crystal and the second piezoelectric single crystal deform (extend or shorten), so as to adjust the tilt angle or the lifting height of the level connector in one direction; and by applying a voltage to the third piezoelectric single crystal and the fourth piezoelectric single crystal, the third piezoelectric single crystal and the fourth piezoelectric single crystal deform, so as to adjust the tilt angle or the lifting height of the end surfaces thereof in another direction. The two adjusted angles are transferred through the level connector to the ends (the driving surfaces formed by the third piezoelectric single crystal and the fourth piezoelectric single crystal) of the piezoelectric single crystals on the same side of the level connector, thereby achieving the adjustment of the angles in the two directions. Moreover, the adjustment of the axial length can be achieved by the length variations of the piezoelectric single crystals in the axial direction, that is, the three-degree-of-freedom control over the piezoelectric actuator is achieved.

For the deformable mirror using the piezoelectric actuator according to the present invention, by mounting each of the small mirror units on the deformable mirror at the ends of the first piezoelectric single crystal and of the second piezoelectric single crystal of one piezoelectric actuator away from the level connector, or at the ends of the third piezoelectric single crystal and of the fourth piezoelectric single crystal of one piezoelectric actuator away from the level connector, the deformable mirror fixes the ends of the piezoelectric single crystals which are connected with the small mirror units.

By means of the three-degree-of-freedom adjustment of the piezoelectric actuator, it is possible to separately control each of the small mirrors in three directions, and by means of the control over each small mirrors, it is possible to achieve control with high accuracy over the large curved mirror surface of the entire deformable mirror, which reduces the control difficulty and control hysteresis, and increases the control flexibility.

## Claims

1. A piezoelectric actuator (10) for use in a deformable mirror, comprising:
a level connector (300), comprising a first connection surface and a second connection surface which are parallel and opposite to each other,
a first piezoelectric single crystal (111) and a second piezoelectric single crystal (112), both of rectangular shapes, and a third piezoelectric single crystal (121) and a fourth piezoelectric single crystal (122), all of rectangular shapes, wherein one end of the first piezoelectric single crystal (111) and one end of the second piezoelectric single crystal (112) are bonded onto the first connection surface of the level connector and one end of the third piezoelectric single crystal (121) and one end of the fourth piezoelectric single crystal (122) are bonded onto the second connection surface of the level connector, thereby forming a two-layered structure, such that both the first and second piezoelectric single crystals are spaced apart and parallel to one another both in their length, or axial, direction and in their width direction, that both the first and the second piezoelectric single crystals are adapted to extend or contract in their length direction causing the plane connecting to both free ends of the first and second single crystals to displace axially and to tilt about an axis parallel to the width direction of both crystals under effect of externally applied electric fields, that both the third and fourth piezoelectric single crystals (121, 122) are spaced apart and parallel in both their length, or axial, direction and in their width direction, their axial direction being the same but their width direction being at an angle to the axial and width directions, respectively, of the first and second piezoelectric crystals (111, 112), and that both the third and fourth piezoelectric single crystals (121, 122) are adapted to extend or contract in their length direction causing the plane connecting to the free ends of both the third and fourth single crystals to displace axially and to tilt about a different axis which is parallel to the width direction of the third and fourth piezoelectric single crystals under effect of externally applied electric fields; and
a base (410) and a pedestal (420), wherein the free ends of the first and second piezoelectric single crystals (111, 112) are both bonded onto the upper surface of the base (410), and the free ends of the third and fourth piezoelectric single crystals (121, 122) are both bonded onto the lower surface of the pedestal (420);
wherein the top face of the pedestal is able to display three-degree-of-freedom displacement actuation, and wherein a first layer of the two-layered structure is composed of the first piezoelectric single crystal (111) and the second piezoelectric single crystal (112) and a second layer of the two-layered structure is composed of the third piezoelectric single crystal (121) and the fourth piezoelectric single crystal (122).

2. The piezoelectric actuator (10) according to claim 1, wherein the first piezoelectric single crystal (111), the second piezoelectric single crystal (112), the third piezoelectric single crystal (121) and the fourth piezoelectric single crystal (122) are of strip-like structure.

3. The piezoelectric actuator (10) according to claims 1 and 2, wherein the first piezoelectric single crystal (111), the second piezoelectric single crystal (112), the third piezoelectric single crystal (121) and the fourth piezoelectric single crystal (122) are [011]-crystal orientation polarized single crystals of either d₃₂ or d₃₁-mode having [100] and [011] crystal direction as the active direction, respectively.

4. The piezoelectric actuator (10) according to claims 1 to 3, wherein the first piezoelectric single crystal (111), the second piezoelectric single crystal (112), the third piezoelectric single crystal (121) and the fourth piezoelectric single crystal (122) are made of solid solution single crystals comprising at least one selected from the group consisting of lead zinc niobate-lead titanate [Pb(Zn_{1/3}Nb_{2/3})O₃-PbTiO₃], lead magnesium niobate-lead titanate [Pb(Mg_{1/3}Nb_{2/3})O₃-PbTiO₃], lead magnesium niobate-lead zirconate titanate [Pb(Mg_{1/3}Nb_{2/3})O₃-PbZrO₃-PbTiO₃], lead indium niobate-lead magnesium niobate-lead titanate [Pb(In_{1/2}Nb_{1/2})O₃-Pb(Mg_{1/3}Nb_{2/3})O₃-PbTiO₃], and derivative components of them.

5. The piezoelectric actuator (10) according to any one of claims 1 to 4, wherein the level connector is of a rectangular shape having a length and a width direction perpendicular to the axial direction of the piezoelectric actuator and a thickness direction parallel to the axial direction of the piezoelectric actuator .

6. The piezoelectric actuator (10) according to any one of claims 1 to 5, wherein the first piezoelectric single crystal (111), the second piezoelectric single crystal (112), the third piezoelectric single crystal (121) and the fourth piezoelectric single crystal (122) each has a length direction parallel with the axial direction of the piezoelectric actuator, hence the thickness direction of the level connector, and a width direction parallel to either the length or width direction of the level connector.

7. The piezoelectric actuator (10) according to any one of claims 1 to 6,
wherein the first connection surface of the level connector is provided thereon with two parallel recesses (310), the second connection surface is provided thereon with two parallel recesses (310), and the two sets of recesses are respectively aligned with the length and width directions of the level connector and are thus perpendicular to one another;
wherein the first piezoelectric single crystal (111) and the second piezoelectric single crystal (112) are bonded onto the base of the recesses (310) on the first connection surface, and the third piezoelectric single crystal (121) and the fourth piezoelectric single crystal (122) are bonded at the base of the recesses on the second connection surface;
wherein an upper face of the base (410) is provided thereon with two recesses that are arranged in parallel and spaced apart and the ends of the first piezoelectric single crystal (111) and the second piezoelectric single crystal (112) opposite to the level connector are bonded onto the base of the two recesses on the upper face of the base (410);
wherein a lower face of the pedestal (420) is provided thereon with two recesses that are arranged in parallel and spaced apart; and the ends of the third piezoelectric single crystal (121) and the fourth piezoelectric single crystal (122) opposite to the level connector are bonded onto the base of the two recesses on the lower face of the pedestal (420);
wherein the two sets of recesses on the upper face of the base and on the lower face of the pedestal, respectively, are orthogonal to one another by nature of the orientation arrangement of the above-said four piezoelectric single crystals.

8. The piezoelectric actuator (10) according to any one of claims 1 to 7, wherein the first piezoelectric single crystal (111), the second piezoelectric single crystal (112), the third piezoelectric single crystal (121) and the fourth piezoelectric single crystal (122) may or may not be of same size.

9. A deformable mirror, **characterized by** comprising a plurality of piezoelectric actuators (10) according to any one of claims 1 to 8 that are arranged in a matrix.

10. A method for manufacturing a deformable mirror, **characterized by** comprising steps of:
a) mounting the bases of a plurality of piezoelectric actuators according to any one of claims 1 to 8 on a rigid base and arranging the plurality of piezoelectric actuators in a matrix; and
b) performing flat-lapping and mirror-polishing on upper surfaces of the pedestals of the plurality of piezoelectric actuators.

11. The method for manufacturing a deformable mirror according to claim 10, wherein the polished upper surface of the pedestal is further covered with a coating having high reflectivity.

12. A method for manufacturing a deformable mirror, **characterized by** comprising steps of:
a) mounting the bases of a plurality of piezoelectric actuators according to any one of claims 1 to 8 on a rigid base and arranging the plurality of piezoelectric actuators in a matrix; and
b) performing flat-lapping of the upper surfaces of the pedestals of the plurality of piezoelectric actuators; and
c) bonding a small mirror body onto the upper surface of the pedestal of each of the plurality of piezoelectric actuators.

## Patentansprüche

1. Piezoelektrischer Aktuator (10) zur Verwendung in einem verformbaren Spiegel, wobei der Aktuator umfasst:
ein Ebenen-Verbindungselement (300), das eine erste Verbindungsfläche und eine zweite Verbindungsfläche umfasst, die parallel zueinander sind und einander gegenüber liegen,
einen ersten piezoelektrischen Einkristall (111) und einen zweiten piezoelektrischen Einkristall (112), beide von rechteckiger Form, und einen dritten piezoelektrischen Einkristall (121) und einen vierten piezoelektrischen Einkristall (122), alle von rechteckiger Form, wobei ein Ende des ersten piezoelektrischen Einkristalls (111) und ein Ende des zweiten piezoelektrischen Einkristalls (112) auf die erste Verbindungsfläche des Ebenen-Verbindungselements gebondet sind und ein Ende des dritten piezoelektrischen Einkristalls (121) und ein Ende des vierten piezoelektrischen Einkristalls (122) auf die zweite Verbindungsfläche des Ebenen-Verbindungselements gebondet sind, wodurch eine zweilagige Struktur gebildet wird, so dass der erste und zweite piezoelektrische Einkristall voneinander beabstandet sind und in ihrer longitudinalen oder axialen Richtung und in ihrer Breitenrichtung parallel zueinander sind, der erste und der zweite piezoelektrische Einkristall so ausgelegt sind, dass sie sich in ihrer Längenrichtung ausdehnen oder zusammenziehen können, um zu bewirken, dass die Ebene, die beide freie Enden des ersten und des zweiten Einkristalls verbindet, axial verschoben und um eine Achse parallel zur Breitenrichtung der beiden Kristalle unter Wirkung angelegter äußerer elektrischer Felder gekippt wird, der dritte und der vierte piezoelektrische Einkristall (121, 122) beabstandet sind und in ihrer longitudinalen oder axialen Richtung und in ihrer Breitenrichtung parallel zueinander sind, wobei ihre axiale Richtung gleich ist, ihre Breitenrichtung jedoch jeweils in einem Winkel zur axialen und Breitenrichtung des ersten und des zweiten piezoelektrischen Einkristalls (111, 112) verläuft, und der dritte und vierte piezoelektrische Einkristall (121, 122) so ausgelegt sind, dass sie sich in ihrer Längenrichtung ausdehnen oder zusammenziehen können, um zu bewirken, dass die Ebene, die mit den freien Enden des dritten und vierten Einkristalls verbunden ist, axial verschoben und um eine andere Achse, die parallel zur Breitenrichtung des dritten und vierten piezoelektrischen Einkristalls ist, unter Wirkung angelegter äußerer elektrischer Felder gekippt wird; und
eine Basis (410) und einen Sockel (420), wobei die freien Enden des ersten und zweiten piezoelektrischen Einkristalls (111, 112) beide auf die obere Oberfläche der Basis (410) gebondet sind und die freien Enden des dritten und des vierten piezoelektrischen Einkristalls (121, 122) beide auf die untere Oberfläche des Sockels (420) gebondet sind;
wobei die Oberseite des Sockels eine Verlagerungsoperation mit drei Freiheitsgraden anzeigen kann, und
wobei eine erste Lage der zweilagigen Struktur aus dem ersten piezoelektrischen Einkristall (111) und dem zweiten piezoelektrischen Einkristall (112) aufgebaut ist und eine zweite Lage der zweilagigen Struktur aus dem dritten piezoelektrischen Einkristall (121) und dem vierten piezoelektrischen Einkristall (122) aufgebaut ist.

2. Piezoelektrischer Aktuator (10) nach Anspruch 1, wobei der erste piezoelektrische Einkristall (111), der zweite piezoelektrische Einkristall (112), der dritte piezoelektrische Einkristall (121) und der vierte piezoelektrische Einkristall (122) einen streifenartigen Aufbau haben.

3. Piezoelektrischer Aktuator (10) nach Anspruch 1 und 2, wobei der erste piezoelektrische Einkristall (111), der zweite piezoelektrische Einkristall (112), der dritte piezoelektrische Einkristall (121) und der vierte piezoelektrische Einkristall (122) polarisierte Einkristalle mit einer [011]-Kristallorientierung der d₃₂- oder der d₃₁-Mode sind, die jeweils eine [100]- und eine [011]-Kristallrichtung als die aktive Richtung haben.

4. Piezoelektrischer Aktuator (10) nach Anspruch 1 bis 3, wobei der erste piezoelektrische Einkristall (111), der zweite piezoelektrische Einkristall (112), der dritte piezoelektrische Einkristall (121) und der vierte piezoelektrische Einkristall (122) aus Mischkristall-Einkristallen hergestellt sind, die wenigstens eines umfassen, das aus der Gruppe ausgewählt wird, die aus Blei-Zink-Niobat-Bleititanat [Pb(Zn_{1/3}Nb_{2/3})O₃-PbTiO₃], Blei-Magnesium-Niobat-Bleititanat [Pb(Mg_{1/3}Nb_{2/3})O₃-PbTiO₃], Blei-Magnesium-Niobat-Bleizirkonat-Titanat [Pb(Mg_{1/3}Nb_{2/3})O₃-PbZrO₃-PbTiO₃], Blei-Indium-Niobat-Blei-Magnesium-Niobat-Bleititanat [Pb(In_{1/2}Nb_{1/2})O₃- Pb(Mg_{1/3}Nb_{2/3})O₃-PbTiO₃] und Derivat-Komponenten davon besteht.

5. Piezoelektrischer Aktuator (10) nach einem der Ansprüche 1 bis 4, wobei das Ebenen-Verbindungselement eine rechteckige Form hat, die eine Längen- und eine Breitenrichtung senkrecht zur axialen Richtung des piezoelektrischen Aktuators und eine Dickenrichtung parallel zu axialen Richtung des piezoelektrischen Aktuators hat.

6. Piezoelektrischer Aktuator (10) nach einem der Ansprüche 1 bis 5, wobei der erste piezoelektrische Einkristall (111), der zweite piezoelektrische Einkristall (112), der dritte piezoelektrische Einkristall (121) und der vierte piezoelektrische Einkristall (122) jeweils eine Längenrichtung parallel zur axialen Richtung des piezoelektrischen Aktuators, d.h. der Dickenrichtung des Ebenen-Verbindungselements, und eine Breitenrichtung parallel zur Längen- oder Breitenrichtung des Ebenen-Verbindungselements hat.

7. Piezoelektrischer Aktuator (10) nach einem der Ansprüche 1 bis 6,
wobei die erste Verbindungsfläche des Ebenen-Verbindungselements mit zwei parallelen Aussparungen (310) versehen ist, die zweite Verbindungsfläche mit zwei parallelen Aussparungen (310) versehen ist, und die zwei Sätze von Aussparungen jeweils auf die Längen- und Breitenrichtung des Ebenen-Verbindungselements ausgerichtet sind und folglich senkrecht zueinander sind;
wobei der erste piezoelektrische Einkristall (111) und der zweite piezoelektrische Einkristall (112) auf die Basis der Aussparungen (310) auf der ersten Verbindungsfläche gebondet sind, und der dritte piezoelektrische Einkristall (121) und der vierte piezoelektrische Einkristall (122) auf die Basis der Aussparungen auf der zweiten Verbindungsfläche gebondet sind;
wobei eine Oberseite der Basis (410) mit zwei Aussparungen versehen ist, die parallel zueinander und voneinander beabstandet angeordnet sind, und wobei die Enden des ersten piezoelektrischen Einkristalls (111) und des zweiten piezoelektrischen Einkristalls (112) gegenüber dem Ebenen-Verbindungselement auf die Basis der zwei Aussparungen auf der Oberseite der Basis (410) gebondet sind;
wobei eine Unterseite des Sockels (420) mit zwei Aussparungen versehen ist, die parallel zueinander und voneinander beabstandet angeordnet sind, und wobei die Enden des dritten piezoelektrischen Einkristalls (121) und des vierten piezoelektrischen Einkristalls (122) gegenüber dem Ebenen-Verbindungselement auf die Basis der zwei Aussparungen auf der Unterseite des Sockels (420) gebondet sind;
wobei die zwei Gruppen von Aussparungen auf der Oberseite der Basis und auf der Unterseite des Sockels durch die Orientierungsanordnung der zuvor erwähnten vier piezoelektrischen Einkristalle jeweils orthogonal zueinander sind.

8. Piezoelektrischer Aktuator (10) nach einem der Ansprüche 1 bis 7, wobei der erste piezoelektrische Einkristall (111), der zweite piezoelektrische Einkristall (112), der dritte piezoelektrische Einkristall (121) und der vierte piezoelektrische Einkristall (122) die gleiche oder eine unterschiedliche Form haben können.

9. Verformbarer Spiegel, **dadurch gekennzeichnet, dass** er mehrere piezoelektrische Aktuatoren (10) nach einem der Ansprüche 1 bis 8 umfasst, die in einer Matrix angeordnet sind.

10. Verfahren zum Herstellen eines verformbaren Spiegels, **dadurch gekennzeichnet, dass** es die Schritte umfasst:
a) Montieren der Basen mehrerer piezoelektrischer Aktuatoren nach einem der Ansprüche 1 bis 8 auf eine starre Basis und Anordnen der mehreren piezoelektrischen Aktuatoren in einer Matrix; und
b) Ausführen eines Flachläppens und eines Hochglanzpolierens an oberen Oberflächen der Sockel der mehreren piezoelektrischen Aktuatoren.

11. Verfahren zum Herstellen eines verformbaren Spiegels nach Anspruch 10, wobei die polierte obere Oberfläche des Sockels ferner mit einer Beschichtung bedeckt ist, die ein hohes Reflexionsvermögen hat.

12. Verfahren zum Herstellen eines verformbaren Spiegels, **dadurch gekennzeichnet, dass** es die Schritte umfasst:
a) Montieren der Basen mehrerer piezoelektrischer Aktuatoren nach einem der Ansprüche 1 bis 8 auf eine starre Basis und Anordnen der mehreren piezoelektrischen Aktuatoren in einer Matrix; und
b) Ausführen eines Flachläppens an der oberen Oberflächen der Sockel der mehreren piezoelektrischen Aktuatoren; und
c) Bonden eines kleinen Spiegelkörpers auf die obere Oberfläche des Sockels jedes der mehreren piezoelektrischen Aktuatoren.

## Revendications

1. Actionneur piézoélectrique (10) destiné à être utilisé dans un miroir déformable, comprenant :
un connecteur de niveau (300), comprenant une première surface de connexion et une seconde surface de connexion qui sont parallèles et opposées l'une à l'autre, un premier monocristal piézoélectrique (111) et un deuxième monocristal piézoélectrique (112), présentant tous une forme rectangulaire, et un troisième monocristal piézoélectrique (121) et un quatrième monocristal piézoélectrique (122), présentant tous une forme rectangulaire, dans lequel une extrémité du premier monocristal piézoélectrique (111) et une extrémité du deuxième monocristal piézoélectrique (112), sont collées sur la première surface de connexion du connecteur de niveau, et une extrémité du troisième monocristal piézoélectrique (121) et une extrémité du quatrième monocristal piézoélectrique (122) sont collées sur la seconde surface de connexion du connecteur de niveau, en formant de ce fait une structure à deux couches, de telle sorte que les premier et deuxième monocristaux piézoélectriques soient espacés et parallèles l'un à l'autre dans la direction de la longueur, ou axiale, ou dans la direction de la largeur, de telle sorte que les premier et deuxième monocristaux piézoélectriques soient adaptés pour s'étendre ou se contracter dans la direction de la longueur, en provoquant un déplacement axial du plan qui connecte les deux extrémités libres des premier et deuxième monocristaux, et une inclinaison autour d'un axe parallèle à la direction de la largeur des deux cristaux sous l'effet de champs électriques appliqués extérieurement, de telle sorte que les troisième et quatrième monocristaux piézoélectriques (121, 122) soient espacés et parallèles dans la direction de la longueur, ou axiale, et dans la direction de la largeur, les directions axiales étant identiques, mais les directions de la longueur faisant un angle par rapport aux directions axiales et de la largeur, respectivement, des premier et deuxième cristaux piézoélectriques (111, 112), et de telle sorte que les troisième et quatrièmes monocristaux piézoélectriques (121, 122) soient adaptés pour s'étendre ou se contracter dans la direction de la longueur, en provoquant un déplacement axial du plan qui connecte les extrémités libres des troisième et quatrième monocristaux, et une inclinaison autour d'un axe différent qui est parallèle à la direction de la largeur des troisième et quatrième monocristaux piézoélectriques sous l'effet de champs électriques appliqués extérieurement, et
une base (410) et un socle (420), dans lequel les extrémités libres des premier et deuxième monocristaux piézoélectriques (111, 112) sont toutes deux collées sur la surface supérieure de la base (410), et les extrémités libres des troisième et quatrième monocristaux piézoélectriques (121, 122) sont toutes deux collées sur la surface inférieure du socle (420) ;
dans lequel la face supérieure du socle peut afficher un actionnement de déplacement à trois degrés de liberté,
et dans lequel une première couche de la structure à deux couches se compose du premier monocristal piézoélectrique (111) et du deuxième monocristal piézoélectrique (112), et la seconde couche de la structure à deux couches se compose du troisième monocristal piézoélectrique (121) et du quatrième monocristal piézoélectrique (122).

2. Actionneur piézoélectrique (10) selon la revendication 1, dans lequel le premier monocristal piézoélectrique (111), le deuxième monocristal piézoélectrique (112), le troisième monocristal piézoélectrique (121) et le quatrième monocristal piézoélectrique (122), présentent une structure similaire à une bande.

3. Actionneur piézoélectrique (10) selon les revendications 1 et 2, dans lequel le premier monocristal piézoélectrique (111), le deuxième monocristal piézoélectrique (112), le troisième monocristal piézoélectrique (121) et le quatrième monocristal piézoélectrique (122), sont des monocristaux polarisés à orientation de cristal [011] à mode d₃₂ ou d₃₁, présentant une direction de cristal [100] et [011], en tant que direction active, respectivement.

4. Actionneur piézoélectrique (10) selon les revendications 1 à 3, dans lequel le premier monocristal piézoélectrique (111), le deuxième monocristal piézoélectrique (112), le troisième monocristal piézoélectrique (121) et le quatrième monocristal piézoélectrique (122) sont constitués de monocristaux en solution solide comprenant l'un au moins sélectionné dans le groupe comprenant le niobate de zinc plomb - titanate de plomb [Pb(Zn_{1/3}Nb_{2/3})O₃-PbTiO₃], le niobate de magnésium plomb - titanate de plomb [Pb(Mg_{1/3}Nb_{2/3})O₃-PbTiO₃], le niobate de magnésium plomb - titanate de zirconate plomb [Pb(Mg_{1/3}Nb_{2/3})O₃-PbZrO₃-PbTiO₃], le niobate d'indium plomb - niobate de magnésium plomb - titanate de plomb [Pb(In_{1/2}Nb_{1/2})O₃-Pb(Mg_{1/3}Nb_{2/3})O₃-PbTiO₃], et des composants dérivés de ceux-ci.

5. Actionneur piézoélectrique (10) selon l'une quelconque des revendications 1 à 4, dans lequel le connecteur de niveau est de forme rectangulaire qui présente une longueur et une direction de la largeur perpendiculaire à la direction axiale de l'actionneur piézoélectrique, et une direction de l'épaisseur parallèle à la direction axiale de l'actionneur piézoélectrique.

6. Actionneur piézoélectrique (10) selon l'une quelconque des revendications 1 à 5, dans lequel le premier monocristal piézoélectrique (111), le deuxième monocristal piézoélectrique (112), le troisième monocristal piézoélectrique (121) et le quatrième monocristal piézoélectrique (122), présentent chacun une direction de la longueur parallèle à la direction axiale de l'actionneur piézoélectrique, par conséquent la direction de l'épaisseur du connecteur de niveau, et une direction de la largeur parallèle à la longueur ou à la direction de la largeur du connecteur de niveau.

7. Actionneur piézoélectrique (10) selon l'une quelconque des revendications 1 à 6, dans lequel la première surface de connexion du connecteur de niveau est dotée dessus de deux renfoncements parallèles (310), la seconde surface de connexion est dotée dessus de deux renfoncements parallèles (310), et les deux ensembles de renfoncements sont respectivement alignés avec les directions de longueur et de largeur du connecteur de niveau, et sont ainsi perpendiculaires l'un à l'autre ;
dans lequel le premier monocristal piézoélectrique (111) et le deuxième monocristal piézoélectrique (112), sont collés sur la base des renfoncements (310) sur la première surface de connexion, et le troisième monocristal piézoélectrique (121) et le quatrième monocristal piézoélectrique (122) sont collés sur la base des renfoncements sur la seconde surface de connexion ;
dans lequel la face supérieure de la base (410) est dotée dessus de deux renfoncements qui sont agencés en parallèle et espacés, et les extrémités du premier monocristal piézoélectrique (111) et du deuxième monocristal piézoélectrique (112) opposées au connecteur de niveau, sont collées sur la base des deux renfoncements sur la face supérieure de la base (410) ;
dans lequel la face inférieure du socle (420) est dotée dessus de deux renfoncements qui sont agencés en parallèle et espacés, et les extrémités du troisième monocristal piézoélectrique (121) et du quatrième monocristal piézoélectrique (122) opposées au connecteur de niveau, sont collées sur la base des deux renfoncements sur la face inférieure du socle (420) ;
dans lequel les deux ensembles de renfoncements sur la face supérieure de la base et sur la face inférieure du socle, respectivement, sont orthogonaux l'un à l'autre par nature de l'agencement d'orientation desdits quatre monocristaux piézoélectriques susmentionnés.

8. Actionneur piézoélectrique (10) selon l'une quelconque des revendications 1 à 7, dans lequel le premier monocristal piézoélectrique (111), le deuxième monocristal piézoélectrique (112), le troisième monocristal piézoélectrique (121) et le quatrième monocristal piézoélectrique (122), présentent ou non une taille identique.

9. Miroir déformable, **caractérisé par le fait qu'**il comprend une pluralité d'actionneurs piézoélectriques (10) selon l'une quelconque des revendications 1 à 8, qui sont agencés en une matrice.

10. Procédé destiné à fabriquer un miroir déformable, **caractérisé par le fait qu'**il comprend les étapes suivantes :
a) monter les bases d'une pluralité d'actionneurs piézoélectriques selon l'une quelconque des revendications 1 à 8, sur une base rigide, et agencer la pluralité d'actionneurs piézoélectriques en une matrice ; et
b) exécuter un rodage plan et un polissage miroir sur les surfaces supérieures des socles de la pluralité d'actionneurs piézoélectriques.

11. Procédé destiné à fabriquer un miroir déformable selon la revendication 10, dans lequel la surface supérieure polie du socle est recouverte en outre d'un revêtement qui présente une réflectivité élevée.

12. Procédé destiné à fabriquer un miroir déformable, **caractérisé par le fait qu'**il comprend les étapes suivantes :
a) monter les bases d'une pluralité d'actionneurs piézoélectriques selon l'une quelconque des revendications 1 à 8, sur une base rigide, et agencer la pluralité d'actionneurs piézoélectriques en une matrice ; et
b) exécuter un rodage plan sur les surfaces supérieures des socles de la pluralité d'actionneurs piézoélectriques ; et
c) coller un petit corps de miroir sur la surface supérieure du socle de chacun de la pluralité d'actionneurs piézoélectriques.
